# EUROPEAN PATENT APPLICATION

(11) **EP 2 180 026 A1**
(43) Date of publication of application: **28.04.2010**
(21) Application number: 08791778.7
(22) Date of filing: 29.07.2008
(51) Int. Cl.: C09J 133/08, C09J 4/00, C09J 7/00, C09J 9/02, C09J 151/04, C09J 183/10, H01B 1/22, H01L 21/60, H05K 1/14, H05K 3/32

(54) **ADHESIVE COMPOSITION, FILM-LIKE ADHESIVE, AND CONNECTION STRUCTURE FOR CIRCUIT MEMBER**

(30) Priority: 08.08.2007 JP 2007206871
(71) Applicant: Hitachi Chemical Company, Ltd., Tokyo 163-0449 (JP)
(72) Inventor: IZAWA, Hiroyuki, Tsukuba-shi Ibaraki 300-4247 (JP); SHIRASAKA, Toshiaki, Tsukuba-shi Ibaraki 300-4247 (JP); KATOGI, Shigeki, Tsukuba-shi Ibaraki 300-4247 (JP); KUDOU, Sunao, Chikusei-shi Ibaraki 308-8524 (JP); TOMIZAWA, Keiko, Tsukuba-shi Ibaraki 300-4247 (JP)
(74) Representative: von Kreisler Selting Werner
(86) International application number: PCT/JP2008/063543
(87) International publication number: WO 2009/020005

(57) **Abstract**

The adhesive composition of the invention contains (a) organic fine particles comprising at least one selected from the group consisting of alkyl (meth)acrylate ester-butadiene-styrene copolymer or complexes thereof, alkyl (meth)acrylate ester-silicone copolymer or complexes thereof and silicone-(meth)acrylic acid copolymer or complexes thereof.

## Description

### Technical Field

The present invention relates to an adhesive composition, a film-like adhesive and a connection structure for a circuit member.

### Background Art

Semiconductor elements and liquid crystal display units have traditionally employed various types of adhesive compositions for bonding between the members in their elements. The adhesive compositions must exhibit not adhesion alone, but also heat resistance and reliability under high-temperature, high-humidity conditions.

The adherends used for bonding include printed circuit boards and organic base materials such as polyimides, as well as metals such as copper and aluminum, and base materials with diverse surface conditions, such as ITO, SiN, SiO₂ and the like. The adhesive composition must therefore have a molecular design suited for the adherend.

The conventional adhesive compositions used for semiconductor elements and liquid crystal display units have been thermosetting resins such as epoxy-curing resins employing epoxy resins with high reliability, and radical-curing resins employing radical polymerizing compounds (for example, see Patent documents 1 and 2). The constituent components of epoxy-curing adhesive compositions generally include an epoxy resin, a curing agent such as a phenol resin which is reactive with the epoxy resin, and a thermal latent catalyst that promotes reaction between the epoxy resin and curing agent. The constituent components used for radical-curing adhesive compositions, on the other hand, are radical polymerizing compounds such as acrylate derivatives and methacrylate derivatives, and peroxides as radical polymerization initiators.

However, with the increasingly higher integration of semiconductor elements and high definition of liquid crystal devices in recent years, interelement and interconnect pitches have become narrower to such a point that the heat of curing can adversely affect the peripheral members. Increased throughput is also essential for lowering cost. In light of the above, a demand exists for curing at lower temperatures and in shorter periods of time, i.e. for bonding with low-temperature fast curing. It is known that with fast curing, however, cure shrinkage and the like result in increased internal stress and lower the bonding strength. It is also known that when the curing has been carried out at low temperature, reaction of epoxy resins, acrylate derivatives and methacrylate derivatives proceeds inadequately and the crosslink density is insufficient, thereby lowering the reliability.

Methods proposed to improve bonding strength include methods wherein a radical polymerizing compound with an ether bond is used to impart flexibility to the cured adhesive and improve the bonding strength (see Patent documents 3 and 4, for example), and methods wherein stress-absorbing particles composed of a rubber-based elastic material are dispersed in the adhesive to improve the bonding strength (see Patent document 5, for example).

[Patent document 1] Japanese Unexamined Patent Publication HEI No. 01-113480
[Patent document 2] Japanese Unexamined Patent Publication No. 2002-203427
[Patent document 3] Japanese Patent Publication No. 3522634
[Patent document 4] Japanese Unexamined Patent Publication No. 2002-285 128
[Patent document 5] Japanese Patent Publication No. 3477367

### Disclosure of the Invention

### Problems to be Solved by the Invention

However, adhesives using radical polymerizing compounds with ether bonds, such as described in Patent documents 3 and 4, are problematic when cured at low temperature, because the reaction of ether bond-containing acrylate derivatives or methacrylate derivatives does not proceed sufficiently and the crosslink density is inadequate. Even with the adhesive employing stress-absorbing particles described in Patent document 5, the high glass transition temperature (Tg) of 80°C-120 of the stress-absorbing particles leads to an inadequate stress relaxation effect. Consequently, when these adhesives are used as adhesives for semiconductor elements and liquid crystal display units which must exhibit stable performance even after exposure to high-temperature, high-humidity conditions (for example, 85°C/85% RH) for prolonged periods, the properties such as adhesive force and connection resistance after reliability testing (high-temperature, high-humidity testing) are impaired.

The present invention has been accomplished in light of the aforementioned problems of the prior art, and its object is to provide an adhesive composition which exhibits excellent bonding strength and can maintain stable performance even after reliability testing (for example, standing at 85°C/85% RH), as well as a film-like adhesive and a connection structure for a circuit member employing it.

### Means for Solving the Problems

In order to achieve the object stated above, the invention provides an adhesive composition containing (a) organic fine particles comprising at least one selected from the group consisting of alkyl (meth)acrylate ester-butadiene-styrene copolymer or complexes thereof, alkyl (meth)acrylate ester-silicone copolymer or complexes thereof and silicone-(meth)acrylic acid copolymer or complexes thereof.

Because this adhesive composition contains the (a) organic fine particles, an effect of improved stress-relaxation properties and compatibility with resin compositions is obtained and excellent bonding strength can be achieved, while connection resistance for connection between circuit members can be sufficiently reduced and stable performance can be maintained after reliability testing (for example, standing at 85°C/85% RH).

The adhesive composition of the invention preferably comprises (b) a radical polymerizing compound and (c) a radical polymerization initiator. Because such an adhesive composition comprises a (b) radical polymerizing compound and (c) radical polymerization initiator, the high reactivity of the radical reactive species allows rapid curing to be accomplished. In addition, excellent bonding strength can be obtained and excellent properties can be exhibited after reliability testing (high-temperature, high-humidity testing).

The adhesive composition of the invention also preferably comprises (d) an epoxy resin and (e) a latent curing agent. Since the adhesive composition comprises (d) an epoxy resin and (e) a latent curing agent, excellent bonding strength can be obtained and excellent properties can be exhibited after reliability testing (high-temperature, high-humidity testing).

The Tg of the (a) organic fine particles in the adhesive composition of the invention is preferably -100 to 70°C. If the Tg of the (a) organic fine particles is above 70°C the internal stress in the adhesive will not be adequately relaxed, and therefore the bonding strength will tend to be reduced. If the Tg of the (a) organic fine particles is below -100°C, sufficient cohesion will not be obtained and the physical properties of the adhesive composition will tend to be impaired. The stress-absorbing particles described in Patent document 5 have a high Tg of 80-120°C, and the stress relaxation effect is insufficient.

The (a) organic fine particles in the adhesive composition of the invention are preferably particles comprising a polymer with a three-dimensional crosslinked structure. A crosslinked structure will exhibit adequate cohesion and will allow excellent bonding strength to be obtained while also resulting in excellent properties being exhibited after reliability testing (high-temperature, high-humidity testing).

The (a) organic fine particles in the adhesive composition of the invention are preferably particles comprising a polymer with a weight-average molecular weight of 1,000,000-3,000,000. This will result in entanglement of the molecular chains to exhibit adequate cohesion and allowing excellent bonding strength to be obtained, while also allowing excellent properties to be exhibited after reliability testing (high-temperature, high-humidity testing).

The content of the (a) organic fine particles in the adhesive composition of the invention is preferably 5-80 mass% based on the total solid mass of the adhesive composition. If the (a) organic fine particle content is less than 5 mass% the resulting heat resistance and cohesion may be inadequate, and if it is greater than 80 mass% the flow property may be reduced.

The (a) organic fine particles in the adhesive composition of the invention are preferably particles with a core-shell structure. This will relax interaction between the (a) organic fine particles and lower the structural viscosity (non-Newtonian viscosity), thereby increasing dispersibility in the resin and allowing the performance of the (a) organic fine particles to be effectively exhibited.

The adhesive composition of the invention also preferably contains (f) a vinyl compound with one or more phosphate groups in the molecule. This will allow the adhesive composition to exhibit more excellent bonding strength for base materials, and especially metals.

The adhesive composition of the invention also preferably contains (g) a thermoplastic resin. The adhesive composition comprising the (g) thermoplastic resin has improved film properties and satisfactory manageability.

The (g) thermoplastic resin in the adhesive composition of the invention preferably includes at least one selected from the group consisting of phenoxy resins, polyester resins, polyurethane resins, polyester-urethane resins, butyral resins, acrylic resins and polyimide resins.

The adhesive composition of the invention also preferably contains (h) conductive particles.

The invention further provides a film-like adhesive obtained by shaping the photosensitive adhesive composition of the invention into a film.

The invention still further provides a connection structure for a circuit member comprising a pair of mutually opposing circuit members, and a connecting member formed between the pair of circuit members which bonds the pair of circuit members together so that the respective circuit electrodes of the circuit members are electrically connected together, wherein the connecting member comprises a cured adhesive composition according to the invention.

Since the connecting member connecting the pair of circuit members in this connection structure for a circuit member is constructed of a cured adhesive composition according to the invention, the bonding strength between circuit members can be adequately increased and connection resistance between electrically connected circuit electrodes can be adequately reduced, while stable performance can also be maintained in reliability testing (standing at 85°C/85% RH, for example).

### Effect of the Invention

According to the invention it is possible to provide an adhesive composition which exhibits excellent bonding strength and can maintain stable performance even after reliability testing (for example, standing at 85°C/85% RH), as well as a film-like adhesive and a connection structure for a circuit member employing it.

### Brief Description of the Drawings

Fig. 1 is a schematic cross-sectional view showing an embodiment of a film-like adhesive according to the invention.
Fig. 2 is a schematic cross-sectional view showing an embodiment of a connection structure for a circuit member according to the invention.
Fig. 3(a)-(c) are a series of process steps for connection of circuit members.
Fig. 4 is a schematic cross-sectional view showing an embodiment of a semiconductor device.

### Explanation of Symbols

1: Film-like adhesive, 2: semiconductor device, 5: adhesive component, 7: conductive particles, 10: circuit-connecting member, 11: insulating material, 20: first circuit member, 21: circuit board (first circuit board), 21a: main side, 22: circuit electrode (first circuit electrode), 30: second circuit member, 31: circuit board (second circuit board), 31a: main side, 32: circuit electrode (second circuit electrode), 40: circuit-connecting material film, 50: semiconductor element, 60: board, 61: circuit pattern, 70: sealing material, 80: semiconductor element connecting member.

### Best Mode for Carrying Out the Invention

Preferred embodiments of the invention will now be explained in detail, with reference to the accompanying drawings as necessary. Identical or corresponding parts in the drawings will be referred to by like reference numerals and will be explained only once. According to the invention, "Tg" means the peak top temperature of the loss tangent (tanδ) obtained by measuring the dynamic viscoelasticity. For the purpose of the invention, (meth)acrylic acid refers to acrylic acid and its corresponding methacrylic acid, (meth)acrylate refers to acrylate and its corresponding methacrylate, and (meth)acryloyl group refers to an acryloyl or methacryloyl group.

The adhesive composition of the invention contains (a) organic fine particles comprising at least one selected from the group consisting of alkyl (meth)acrylate ester-butadiene-styrene copolymer or complexes thereof, alkyl (meth)acrylate ester-silicone copolymer or complexes thereof and silicone-(meth)acrylic acid copolymer or complexes thereof. Complexes have different components combined (mixed) without being copolymerized.

The term "alkyl (meth)acrylate ester" refers to an alkyl acrylate ester, alkyl methacrylate ester or a mixture thereof, and "(meth)acrylic acid" refers to an acrylic acid, methacrylic acid or a mixture thereof.

The adhesive composition of the invention preferably also comprises (b) a radical polymerizing compound and (c) a radical polymerization initiator, or (d) an epoxy resin and (e) a latent curing agent, in addition to the (a) organic fine particles.

Preferred as components in the adhesive composition of the invention are (f) vinyl compounds with one or more phosphate groups in the molecule, (g) thermoplastic resins and (h) conductive particles. Each of the components will now be explained in detail.

The (a) organic fine particles according to the invention are particles comprising at least one selected from the group consisting of alkyl (meth)acrylate ester-butadiene-styrene copolymer or complexes thereof, alkyl (meth)acrylate ester-silicone copolymer or complexes thereof and silicone-(meth)acrylic acid copolymer or complexes thereof.

The Tg of the (a) organic fine particles is preferably -100 to 70°C.

The (a) organic fine particles are preferably particles comprising a polymer with a three-dimensional crosslinked structure and/or particles comprising a polymer with a weight-average molecular weight of 1,000,000 or greater. The weight-average molecular weight of the polymer composing the (a) organic fine particles is more preferably 1,000,000-3,000,000.

From the viewpoint of dispersibility in the adhesive composition, the (a) organic fine particles are preferably core-shell type particles such as particles having a core material and a surface layer with a higher glass transition temperature than the glass transition temperature of the core material surface, or particles having a graft layer formed by graft polymerization of a resin onto a core material surface.

The content of the (a) organic fine particles in the adhesive composition of the invention is preferably 5-80 mass% and more preferably 10-70 mass% based on the total solid mass of the adhesive composition. If the (a) organic fine particle content is less than 5 mass% the resulting heat resistance and cohesion may be inadequate, and if it is greater than 80 mass% the flow property may be reduced.

The (b) radical polymerizing compound used for the invention is not particularly restricted and may be any known one. The (b) radical polymerizing compound may be used as a monomer or oligomer, or even as a monomer/oligomer mixture.

As specific (b) radical polymerizing compounds there may be mentioned oligomers such as epoxy (meth)acrylate oligomers, urethane (meth)acrylate oligomers, polyether (meth)acrylate oligomers and polyester (meth)acrylate oligomers, trimethylolpropane tri(meth)acrylate, polyethyleneglycol di(meth)acrylate, polyalkyleneglycol di(meth)acrylate, dicyclopentenyl (meth)acrylate, dicyclopentenyloxyethyl (meth)acrylate, neopentylglycol di(meth)acrylate, dipentaerythritol hexa(meth)acrylate, isocyanuric acid-modified bifunctional (meth)acrylates, isocyanuric acid-modified trifunctional (meth)acrylates, epoxy (meth)acrylates obtained by adding (meth)acrylic acid to the glycidyl groups of bisphenolfluorenediglycidyl ether and compounds obtained by introducing (meth)acryloyloxy groups into compounds obtained by adding ethylene glycol or propylene glycol to the glycidyl groups of bisphenolfluorenediglycidyl ether, and compounds represented by the following general formulas (1) and (2). Any of these compounds may be used alone or in mixtures of two or more. 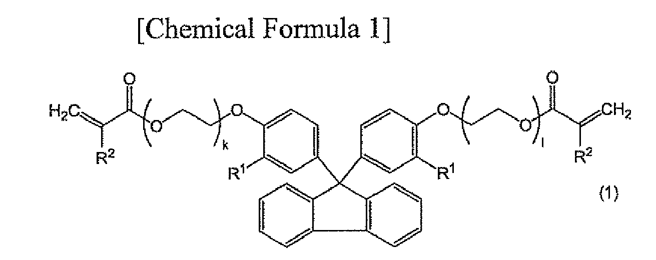 [In the formula, R¹ and R² each independently represent hydrogen or a methyl group, and k and 1 each independently represent an integer of 1-8. The multiple R¹ and R² groups in the formula may be either the same or different.] 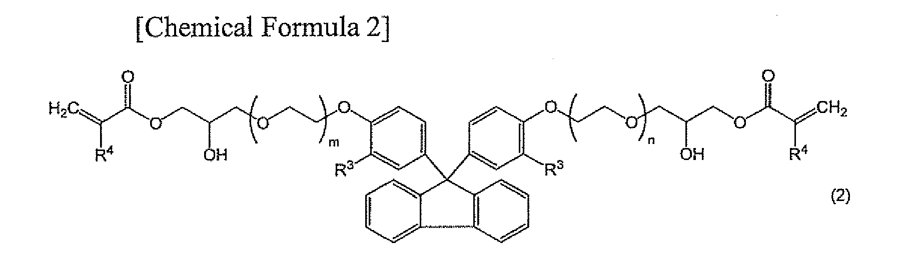 [In the formula, R³ and R⁴ each independently represent hydrogen or a methyl group, and m and n each independently represent an integer of 0-8. The multiple R³ and R⁴ groups in the formula may be either the same or different.]

The content of the (b) radical polymerizing compound in the adhesive composition of the invention is preferably 15-70 mass% and more preferably 25-60 mass% based on the total solid mass of the adhesive composition. If the content is less than 15 mass% the postcuring heat resistant may be lowered, while if it is greater than 60 mass% the film formability may be reduced.

The (c) radical polymerization initiator used for the invention may be a publicly known peroxide or azo compound known in the prior art. From the viewpoint of stability, reactivity and compatibility, the (c) radical polymerization initiator is preferably a peroxide with a one-minute half-life temperature of 90-175°C and a molecular weight of 180-1000. Here, a "one-minute half-life temperature" is the temperature at which the half-life is one minute, and the "half-life" is the time within which the compound concentration is reduced to half its initial value.

As specific (c) radical polymerization initiators there may be mentioned 1,1,3,3-tetramethylbutylperoxy neodecanoate, di(4-t-butylcyclohexyl)peroxy dicarbonate, di(2-ethylhexyl)peroxy dicarbonate, cumylperoxy neodecanoate, 1,1,3,3-tetramethylbutylperoxy neodecanoate, dilauroyl peroxide, 1-cyclohexyl-1-methylethylperoxy neodecanoate, t-hexylperoxy neodecanoate, t-butylperoxy neodecanoate, t-butylperoxy pivalate, 1,1,3,3-tetramethylbutylperoxy-2-ethyl hexanoate, 2,5-dimethyl-2,5-di(2-ethylhexanoylperoxy)hexane, t-hexylperoxy-2-ethyl hexanoate, t-butylperoxy-2-ethyl hexanoate, t-butylperoxy neoheptanoate, t-amylperoxy-2-ethyl hexanoate, di-t-butylperoxy hexahydroterephthalate, t-amylperoxy-3,5,5-trimethyl hexanoate, 3-hydroxy-1,1-dimethylbutylperoxy neodecanoate, 1,1,3,3-tetramethylbutylperoxy-2-ethyl hexanoate, t-amylperoxy neodecanoate, t-amylperoxy-2-ethyl hexanoate, 3-methylbenzoyl peroxide, 4-methylbenzoyl peroxide, di(3-methylbenzoyl)peroxide, dibenzoyl peroxide, di(4-methylbenzoyl)peroxide, 2,2'-azobis-2,4-dimethylvaleronitrile, 1,1'-azobis(1-acetoxy-1-phenylethane), 2,2'-azobisisobutyronitrile, 2,2'-azobis(2-methylbutyronitrile), dimethyl-2,2'-azobisisobutyronitrile, 4,4'-azobis(4-cyanovaleric acid), 1,1'-azobis(1-cyclohexanecarbonitrile), t-hexylperoxyisopropyl monocarbonate, t-butylperoxymaleic acid, t-butylperoxy-3,5,5-trimethyl hexanoate, t-butyl peroxylaurate, 2,5-dimethyl-2,5-di(3-methylbenzoylperoxy)hexane, t-butylperoxy-2-ethylhexyl monocarbonate, t-hexyl peroxybenzoate, 2,5-dimethyl-2,5-di(benzoylperoxy)hexane, t-butyl peroxybenzoate, dibutyl peroxytrimethyladipate, t-amyl peroxy-n-octoate, t-amyl peroxyisononanoate and t-amyl peroxybenzoate. These compounds may be used alone, or two or more different compounds may be used in combination.

According to the invention, the (c) radical polymerization initiator may be a compound that generates radicals by photoirradiation at a wavelength of 150-750 nm. Publicly known compounds may be used as such compounds without any particular restrictions, but more preferred examples are the α-acetoaminophenone derivatives and phosphine oxide derivatives described in Photoinitiation, Photopolymerization, and Photocuring, J.-P. Fouassier, Hanser Publishers (1995), p17-p35, because of their high sensitivity to photoirradiation. These compounds may be used alone, or they may be used in combination with the aforementioned peroxides or azo compounds.

The content of the (c) radical polymerization initiator in the adhesive composition of the invention is preferably 0.1-50 mass% and more preferably 1-30 mass% based on the total solid mass of the adhesive composition. If the content is less than 0.1 mass% the curability may be insufficient, while if it is greater than 50 mass% the standing stability may be reduced.

As examples of (d) epoxy resins to be used for the invention there may be mentioned bisphenol-type epoxy resins derived from epichlorohydrin and bisphenol A, F or AD; epoxy-novolac resins derived from epichlorohydrin and phenol-novolac or cresol-novolac; naphthalene-based epoxy resins having naphthalene ring-containing backbones, and glycidylamine, glycidyl ether and epoxy compounds with two or more glycidyl groups in a biphenyl or alicyclic compound. Any of these may be used alone or in mixtures of two or more. These epoxy resins are preferably high purity products with the impurity ion (Na⁺, Cl⁻, etc.) and hydrolyzable chlorine content reduced to below 300 ppm, in order to prevent electromigration.

As examples of (e) latent curing agents to be used for the invention there may be mentioned imidazole-based curing agents, hydrazide-based curing agents, boron trifluoride-amine complexes, sulfonium salts, amineimides, diaminomaleonitriles, melamine and its derivatives, polyamine salts, dicyandiamides, and modified forms of the foregoing. Any of these may be used alone or in combinations of two or more. Preferred among these are anionic and cationic polymerizable catalyst-type curing agents since they have fast-curing properties and have few special considerations in regard to chemical equivalents. In addition to the (e) latent curing agents mentioned above, there may be used polyaddition-type curing agents such as polyamines, polymercaptanes, polyphenols and acid anhydrides. A polyaddition-type curing agent and a catalyst-type curing agent may also be used in combination.

As anionic polymerizable catalyst-type curing agents there are preferred tertiary amines and imidazoles. Photosensitive onium salts such as aromatic diazonium salts and aromatic sulfonium salts are preferred as cationic polymerizable catalyst-type curing agents when the epoxy resin is to be cured by energy beam irradiation. Aliphatic sulfonium salts are preferred when the epoxy resin is to be cured by activation using heat instead of energy beam exposure. Such curing agents are preferred because of their fast-curing properties.

As examples of (f) vinyl compounds with one or more phosphate groups in the molecule according to the invention there may be mentioned compounds represented by the following general formulas (3)-(5). 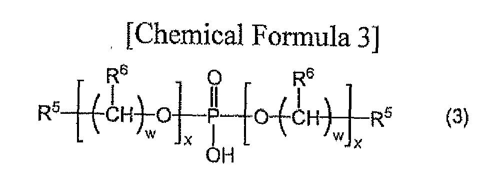 [In this formula, R⁵ represents a (meth)acryloyl group, R⁶ represents hydrogen or a methyl group, and w and x each independently represent an integer of 1-8. Also, each R⁵, R⁶, w and x in the formula may be either the same or different.] 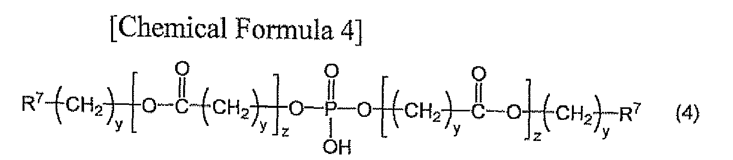 [In this formula, R⁷ represents a (meth)acryloyl group, and y and z each independently represent an integer of 1-8. Also, each R⁷, y and z in the formula may be either the same or different.] 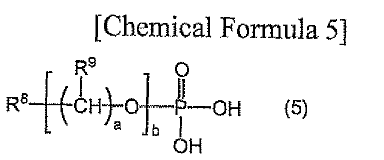 [In this formula, R⁸ represents a (meth)acryloyl group, R⁹ represents hydrogen or a methyl group, and a and b each independently represent an integer of 1-8. Also, each R⁹ and a in the formula may be either the same or different.]

As (f) vinyl compounds with one or more phosphate groups in the molecule there may be mentioned, more specifically, acid phosphooxyethyl methacrylate, acid phosphooxyethyl acrylate, acid phosphooxypropyl methacrylate, acid phosphooxypolyoxyethyleneglycol monomethacrylate, acid phosphooxypolyoxypropyleneglycol monomethacrylate, 2,2'-di(meth)acryloyloxydiethyl phosphate, EO-modified phosphoric acid dimethacrylate, phosphoric acid-modified epoxy acrylate and vinyl phosphate.

The content of the (f) vinyl compound with one or more phosphate groups in the molecule in the adhesive composition of the invention is preferably 0.1-15 mass% and more preferably 0.5-10 mass% based on the total solid mass of the adhesive composition. If the content is less than 0.1 mass% it will be more difficult to obtain high bonding strength, while if it is greater than 15 mass%, the physical properties of the cured adhesive composition will tend to be reduced and the reliability may be impaired.

The (g) thermoplastic resin used for the invention may be any publicly known one, without any particular restrictions. As such (g) thermoplastic resins there may be used phenoxy resins, poly(meth)acrylates, polyimides, polyamides, polyurethanes, polyesters, polyester-urethanes, polyvinyl butyrals and the like. Preferred among these as (g) thermoplastic resins are phenoxy resins, polyester resins, polyurethane resins, polyester-urethane resins, butyral resins, acrylic resins and polyimide resins. Any of these may be used alone or in mixtures of two or more.

These thermoplastic resins may also contain siloxane bonds or fluorine substituents. When two or more of these thermoplastic resins are used in admixture, the two or more resins may be selected so that the resins to be mixed are fully miscible, or exhibit microphase separation to an opaque state. These thermoplastic resins exhibit film formability more readily with larger molecular weights, allowing a wide range to be set for the melt viscosity which affects the flow property of the adhesive composition or film-like adhesive.

There are no particular restrictions on the molecular weight of the (g) thermoplastic resin, but generally a weight-average molecular weight of 5,000-150,000 is preferred, with 10,000-80,000 being more preferred. A value of less than 5,000 will tend to result in inferior film formability, while a value of greater than 150,000 will tend to reduce the compatibility with other components.

The content of the (g) thermoplastic resin in the adhesive composition of the invention is preferably 5-80 mass% and more preferably 15-70 mass% based on the total solid mass of the adhesive composition. A content of less than 5 mass% will tend to reduce the film formability, while a proportion of greater than 80 mass% will tend to impair the flow property of the adhesive composition.

As examples of (h) conductive particles for the invention there may be mentioned metallic particles such as Au, Ag, Ni, Cu or solder, or carbon particles. Alternatively, the (h) conductive particles may have non-conductive glass, ceramic, plastic or the like as a core covered with the aforementioned metals or metallic particles, carbon or the like. When the (h) conductive particles have a plastic nucleus and are covered with the aforementioned metal or metallic particles or carbon, or when they are heat-fusible metallic particles, they will be deformable by heated pressure, so that when used to connect circuit members together the contact area between the conductive particles and electrodes will be increased, thereby improving the reliability.

Fine particles having the surfaces of the conductive particles further covered with a polymer resin or the like will prevent shorting that occurs between particles when the conductive particle content is increased, and will thus improve the insulating property between circuit electrodes. Particles having the conductive particle surfaces covered with a polymer resin may be used alone or in combination with other conductive particles.

The mean particle size of the (h) conductive particles is preferably 1-18 µm from the viewpoint of achieving satisfactory dispersibility and conductivity.

If the adhesive composition comprises such (h) conductive particles, it can be suitably used as an anisotropic conductive adhesive composition.

The content of the (h) conductive particles in the adhesive composition of the invention is not particularly restricted, but it is preferably 0.1-30 vol% and more preferably 0.1-10 vol% based on the total solid volume of the adhesive composition. If the content is less than 0.1 vol% the conductivity may be impaired, and if it is greater than 30 vol% there will be a greater tendency for shorting to occur between circuit electrodes. The content (vol%) of the (h) conductive particles is determined by the volume of each component before curing at 23°C. The volume of each component can be determined by utilizing the specific gravity for conversion from mass to volume. It may also be determined by placing an appropriate solvent (water, alcohol or the like), which is capable of thoroughly wetting the component whose volume is to measured without dissolving or swelling the component, in a graduated cylinder, introducing the component to be measured, and determining the increase in volume as the volume of the component.

A stabilizer may also be added to the adhesive composition of the invention in order to control the curing speed and impart storage stability. Any known stabilizers may be used without any particular restrictions, although quinone derivatives such as benzoquinone and hydroquinone, phenol derivatives such as 4-methoxyphenol and 4-t-butylcatechol, aminoxyl derivatives such as 2,2,6,6-tetramethylpiperidine-1-oxyl and 4-hydroxy-2,2,6,6-tetramethylpiperidine-1-oxyl, and hindered amine derivatives such as tetramethylpiperidyl methacrylate are preferred.

The amount of stabilizer added is preferably 0.01-30 mass% and more preferably 0.05-10 mass% based on the total solid mass of the adhesive composition. If the amount of addition is less than 0.01 mass% the effect of the addition may not be sufficiently obtained, while if it is greater than 30 mass% the compatibility with other components may be reduced.

The adhesive composition of the invention may also contain added coupling agents such as alkoxysilane derivatives or silazane derivatives, or adhesion aids such as adhesion enhancers and leveling agents, as appropriate. Specifically, compounds represented by the following general formula (6) are preferred as adhesion aids. These adhesion aids may be used alone or in mixtures of two or more. 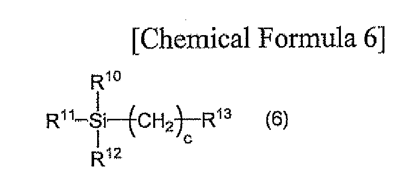 [In the formula, R¹⁰, R¹¹ and R¹² each independently represent hydrogen, C1-5 alkyl, C1-5 alkoxy, C1-5 alkoxycarbonyl or aryl, R¹³ represents (meth)acryloyl, vinyl, isocyanato, imidazole, mercapto, amino, methylamino, dimethylamino, benzylamino, phenylamino, cyclohexylamino, morpholino, piperazino, ureido or glycidyl, and c represents an integer of 1-10.]

A rubber component may also be added to the adhesive composition of the invention for improved stress relaxation and adhesion. As specific rubber components there may be mentioned polyisoprene, polybutadiene, carboxyl-terminated polybutadiene, hydroxyl-terminated polybutadiene, 1,2-polybutadiene, carboxyl-terminated 1,2-polybutadiene, hydroxyl-terminated 1,2-polybutadiene, acrylic rubber, styrene-butadiene rubber, hydroxyl-terminated styrene-butadiene rubber, acrylonitrile-butadiene rubber, acrylonitrile-butadiene rubber having a carboxyl, hydroxyl, (meth)acryloyl group or morpholine group on the polymer ends, carboxylated nitrile rubber, hydroxyl-terminated poly(oxypropylene), alkoxysilyl group-terminated poly(oxypropylene), poly(oxytetramethylene)glycol, polyolefin glycols and poly-ε-caprolactone.

From the viewpoint of enhancing adhesion, these rubber components are preferably rubber components containing highly polar groups such as cyano or carboxyl on a side chain or at the end, while from the viewpoint of improving the flow property they are even more preferably liquid rubber components. As specific rubber components there may be mentioned liquid acrylonitrile-butadiene rubber, liquid acrylonitrile-butadiene rubber containing carboxyl, hydroxyl, (meth)acryloyl or morpholine groups at the polymer ends, and liquid carboxylated nitrile rubber. The polar acrylonitrile content of these rubber components is preferably 5-60 mass%. Any of these compounds may be used alone or in mixtures of two or more.

There are no particular restrictions on the form in which the adhesive composition of the invention is used, and for example, each component may be used as a solution in a solvent and/or as a dispersed coating solution. There are also no particular restrictions on the solvent, and as examples there may be mentioned toluene, methyl ethyl ketone (MEK), ethyl acetate, isopropyl acetate and the like.

The adhesive composition of the invention may be used as a film-like adhesive by coating a composition comprising each component onto a releasable base material such as a fluorine resin film, a polyethylene terephthalate film or a release sheet, or impregnating a base material such as a nonwoven fabric and placing it on a releasable base material.

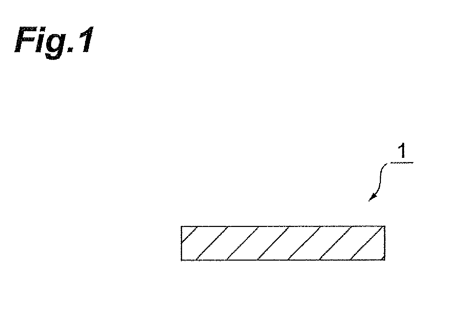

Fig. 1 is a schematic cross-sectional view showing an embodiment of a film-like adhesive according to the invention. The film-like adhesive 1 shown in Fig. 1 is obtained by forming a film from the adhesive composition comprising each of the components mentioned above. The film-like adhesive 1 is manageable and may be easily placed on adherends to facilitate connection. The film-like adhesive 1 may also have a multilayer structure composed of two or more layers (not shown). When the film-like adhesive 1 comprises the (h) conductive particles (not shown), it can be suitably used as an anisotropic conductive film.

For most purposes, the adhesive composition and film-like adhesive 1 of the invention may be bonded with the adherend by a combination of heating and pressurization. The heating temperature is not particularly restricted but is preferably a temperature of 100-250°C. The pressure is not particularly restricted so long as it is in a range that does not damage the adherend, and for most purposes it is preferably 0.1-10 MPa. The heating and pressurization are preferably carried out for a period in a range of 0.5-120 seconds. Since the adhesive composition and film-like adhesive 1 of the invention are curable rapidly and at low temperature, they are able to provide sufficient bonding between adherends even by, for example, heating and pressurization for a brief period of 10 seconds under conditions of 140-200°C, 3 MPa.

The adhesive composition and film-like adhesive 1 of the invention may be used as an adhesive for adherends with different thermal expansion coefficients. Specifically, they may be used as circuit connection materials such as anisotropic conductive adhesives, silver pastes, silver films and the like, or as semiconductor element adhesive materials such as CSP elastomers, CSP underfill materials, LOC tapes and the like.

The following example illustrates the use of the film-like adhesive of the invention as an anisotropic conductive film for connection between circuit members formed on circuit electrodes on the main sides of circuit boards. Specifically, the anisotropic conductive film may be placed between circuit electrodes facing each other on circuit boards and heated and pressed to accomplish electrical connection between the facing circuit electrodes and bonding between the circuit boards, for connection of the circuit members. The circuit boards on which the circuit electrodes are formed may be boards made of inorganic materials such as semiconductors, glass, ceramic or the like, boards made of organic materials such as polyimide or polycarbonate, or boards comprising a combination of inorganic and organic materials such as glass/epoxy. When a film-like adhesive of the invention is used as a circuit connection material in this manner, it preferably also contains conductive particles. The adhesive composition of the invention may also be used instead of the film-like adhesive, for direct coating onto the circuit board.

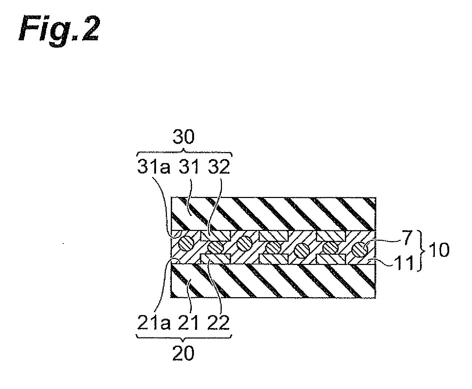

Fig. 2 is a simplified cross-sectional view showing an embodiment of a circuit connection structure (connection structure for a circuit member) according to the invention. As shown in Fig. 2, the connection structure for a circuit member of this embodiment comprises a first circuit member 20 and a second circuit member 30 which are mutually opposing, and a circuit-connecting member 10 which is formed between the first circuit member 20 and second circuit member 30 and connects them.

The first circuit member 20 comprises a circuit board (first circuit board) 21, and circuit electrodes (first circuit electrodes) 22 formed on the main side 21a of the circuit board 21. An insulating layer (not shown) may also be formed on the main side 21a of the circuit board 21.

The second circuit member 30 comprises a circuit board (second circuit board) 31, and a circuit electrode (second circuit electrode) 32 formed on the main side 31 a of the circuit board 31. An insulating layer (not shown) may also be formed on the main side 31a of the circuit board 31.

The first and second circuit members 20, 30 are not particularly restricted so long as they contain the electrodes which require electrical connection. Specifically, there may be mentioned glass or plastic boards, printed circuit boards, ceramic circuit boards, flexible circuit boards, semiconductor silicon chips and the like, on which electrodes are formed by ITO for use in liquid crystal display devices, and these may also be used in combination as necessary. According to this embodiment, therefore, it is possible to use printed circuit boards and circuit members with many and various surface forms including materials composed of organic materials such as polyimides, or inorganic materials which may be metals such as copper or aluminium, ITO (indium tin oxide), silicon nitride (SiNₓ), silicon dioxide (SiO₂) or the like.

The circuit-connecting member 10 is composed of a cured adhesive composition or film-like adhesive according to the invention. The circuit-connecting member 10 comprises an insulating material 11 and conductive particles 7. The conductive particles 7 are situated not only between the opposing circuit electrode 22 and circuit electrode 32, but also between the main sides 21 a and 31 a. In the connection structure for a circuit member, the circuit electrodes 22, 32 are electrically connected via the conductive particles 7. That is, the conductive particles 7 directly connect the circuit electrodes 22, 32.

The conductive particles 7 are the (h) conductive particles described above, and the insulating material 11 is the cured product of each insulating component composing the adhesive composition or film-like adhesive of the invention.

In this connection structure for a circuit member, the facing circuit electrode 22 and circuit electrode 32 are electrically connected via the conductive particles 7, as mentioned above. Connection resistance between the circuit electrodes 22, 32 is therefore sufficiently reduced. Consequently, smooth current flow can be achieved between the circuit electrodes 22, 32, to allow the function of the circuit to be adequately exhibited. When the circuit-connecting member 10 does not contain conductive particles 7, the circuit electrode 22 and circuit electrode 32 are electrically connected by being in direct contact.

Since the circuit-connecting member 10 is composed of a cured adhesive composition or film-like adhesive of the invention, the bonding strength of the circuit-connecting member 10 for the circuit member 20 or 30 is sufficiently high and stable performance (bonding strength and connection resistance) can be maintained even after reliability testing (high-temperature, high-humidity testing).

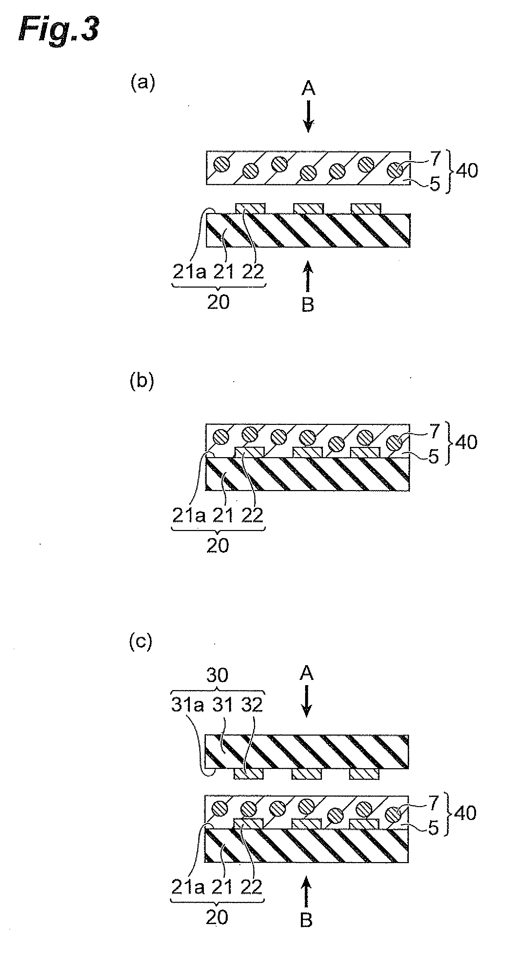

An example of a process for manufacturing the connection structure for a circuit member described above will now be explained. First, the first circuit member 20 and film-like adhesive (circuit-connecting material film) 40 are prepared (see Fig. 3(a)). The circuit-connecting material film 40 is obtained by forming the adhesive composition (circuit-connecting material) of the invention into a film, and it comprises the conductive particles 7 and adhesive component 5. When the circuit connection material does not contain conductive particles 7, the circuit connection material may be used as an insulating adhesive for anisotropic conductive bonding, in which case it is sometimes referred to as NCP (Non-Conductive Paste). When the circuit connection material contains conductive particles 7, the circuit connection material is sometimes referred to as ACP (Anisotropic Conductive Paste).

The thickness of the film-like circuit connection material 40 is preferably 10-50 µm. If the thickness of the film-like circuit connection material 40 is less than 10 µm, the circuit connection material may fail to sufficiently fill the area between the circuit electrodes 22, 32. If it is greater than 50 µm, on the other hand, the adhesive composition between the circuit electrodes 22, 32 will not be sufficiently eliminated between the circuit electrodes 22, 32, and therefore securing the conduction between the circuit electrodes 22, 32 will tend to become difficult.

The film-like circuit connection material 40 is then placed over the side of the first circuit member 20 on which the circuit electrode 22 has been formed. When the film-like circuit connection material 40 is attached onto a support (not shown), the film-like circuit connection material 40 is placed on the first circuit member 20 facing the first circuit member 20. The film-like circuit connection material 40 is easy to manage since it is in the form of a film. Thus, the film-like circuit connection material 40 may be easily situated between the first circuit member 20 and second circuit member 30 in order to facilitate the operation of connecting the first circuit member 20 and second circuit member 30.

The film-like circuit connection material 40 is pressed in the direction of the arrows A and B in Fig. 3(a) to provisionally join the film-like circuit connection material 40 with the first circuit member 20 (see Fig. 3(b)). The pressing may be carried out with heating. However, the heating temperature must be a temperature at which the adhesive composition in the film-like circuit connection material 40 does not cure, i.e. at a lower temperature than the temperature at which the radical polymerization initiator generates radicals.

Next, as shown in Fig. 3(c), the second circuit member 30 is placed on the film-like circuit connection material 40 with the second circuit electrode facing the first circuit member 20. When the film-like circuit connection material 40 is attached onto a support (not shown), the second circuit member 30 is placed on the film-like circuit connection material 40 after releasing the support.

The film-like circuit connection material 40 is then pressed via the first and second circuit members 20, 30 in the direction of the arrows A and B in Fig. 3(c), while heating. The heating temperature is a temperature that allows radicals to be generated by the radical polymerization initiator. This will cause the radical polymerization initiator to generate radicals to initiate polymerization of the radical polymerizing compound. The film-like circuit connection material 40 is subjected to curing treatment for the main connection to obtain a connection structure for a circuit member as shown in Fig. 2.

The connecting conditions are preferably, as mentioned above, a heating temperature of 100-250°C, a pressure of 0.1-10 MPa and a connecting time of 0.5 seconds-120 seconds. The conditions for the procedure may be appropriately selected according to the purpose of use, the adhesive composition and the circuit member, and postcuring may also be performed if necessary.

By manufacturing a connection structure for a circuit member in the manner described above, it is possible to establish contact between both circuit electrodes 22, 32 facing the conductive particles 7 in the connection structure for a circuit member, and thereby adequately reduce connection resistance between the circuit electrodes 22, 32.

Heating of the film-like circuit connection material 40 hardens the adhesive component 5 with a sufficiently small distance between the circuit electrode 22 and circuit electrode 32, thus forming an insulating material 11 and firmly connecting the first circuit member 20 and second circuit member 30 via the circuit-connecting member 10. That is, since the circuit-connecting member 10 in the obtained connection structure for a circuit member is made from a cured circuit-connecting material comprising a film-like adhesive according to the invention, the bonding strength of the circuit-connecting member 10 for the circuit member 20 or 30 is sufficiently increased, and connection resistance between the electrically connected circuit electrodes can be adequately reduced.

Incidentally, although the adhesive component 5 used for this embodiment contains a radical polymerization initiator that generates radicals at least by heating, a radical polymerization initiator that generates radicals by photoirradiation alone may be used instead of this type of radical polymerization initiator. In this case, photoirradiation may be employed instead of heating for curing of the film-like circuit connection material 40. Also, while the connection structure for a circuit member of this embodiment was fabricated using the film-like circuit connection material 40, a circuit connection material that is not in the form of a film may be used instead of the film-like circuit connection material 40. In this case as well, dissolving the circuit connection material in a solvent and coating and drying the solution on either or both the first circuit member 20 and second circuit member 30 can form a circuit connection material between the first and second circuit members 20, 30.

Moreover, instead of a radical polymerization initiator that generates radicals by heat or photoirradiation as in the process for manufacturing a connection structure for a circuit member described above, a radical polymerization initiator that generates radicals by ultrasonic waves, electromagnetic waves or the like may be used as required. The adhesive component 5 may comprise an epoxy resin and its latent curing agent.

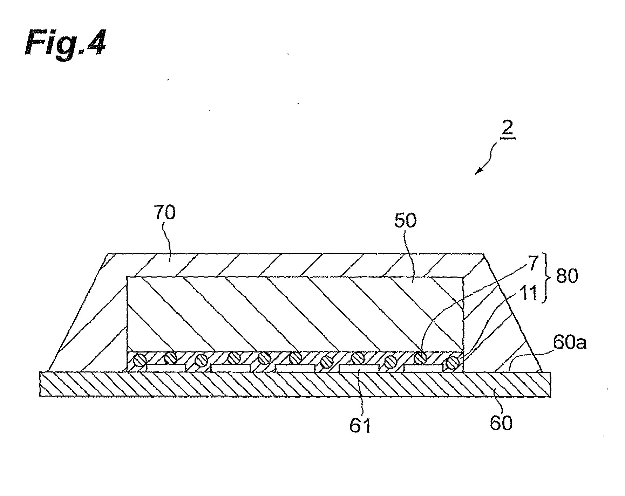

Fig. 4 is a schematic cross-sectional view showing an embodiment of a semiconductor device fabricated using a film-like adhesive according to the invention. As shown in Fig. 4, the semiconductor device 2 comprises a semiconductor element 50 and a board 60 serving as the semiconductor supporting member, and a semiconductor element connecting member 80 is provided between the semiconductor element 50 and board 60, electrically connecting them. The semiconductor element connecting member 80 is laminated on the main side 60a of the board 60, and the semiconductor element 50 is further laminated over the semiconductor element connecting member 80.

The board 60 is provided with a circuit pattern 61, and the circuit pattern 61 is electrically connected via the semiconductor connecting member 80 on the main side 60a of the board 60, or directly with the semiconductor element 50. These are sealed with a sealing material 70 to form the semiconductor device 2.

The material for the semiconductor element 50 is not particularly restricted, and there may be used various types including Group 4 semiconductor elements such as silicon or germanium, Group III-V compound semiconductor elements such as GaAs, InP, GaP, InGaAs, InGaAsP, AlGaAs, InAs, GaInP, AlInP, AlGaInP, GaNAs, GaNP, GaInNAs, GaInNP, GaSb, InSb, GaN, AlN, InGaN or InNAsP, Group II-VI compound semiconductor elements such as HgTe, HgCdTe, CdMnTe, CdS, CdSe, MgSe, MgS, ZnSe or ZeTe, and CuInSe (CIS).

The semiconductor element connecting member 80 comprises an insulating material 11 and conductive particles 7. The conductive particles 7 are situated not only between the semiconductor element 50 and circuit pattern 61, but also between the semiconductor element 50 and the main side 60a. In the semiconductor device 2, the semiconductor element 50 and circuit pattern 61 are electrically connected via the conductive particles 7. Connection resistance between the semiconductor element 50 and circuit pattern 61 is therefore adequately reduced. Consequently, smooth current flow can be achieved between the semiconductor element 50 and circuit pattern 61, to allow the function of the semiconductor to be adequately exhibited.

When the semiconductor element connecting member 80 lacks the conductive particles 7, electrical connection is accomplished by direct contact or sufficient proximity between the semiconductor element 50 and circuit pattern 61 for the desired volume of current to flow.

The semiconductor element connecting member 80 is made from a cured film-like adhesive according to the invention. This will satisfactory increase the bonding strength of the semiconductor element connecting member 80 for the semiconductor element 50 and board 60, while also adequately lowering connection resistance between the semiconductor element 50 and circuit pattern 61. The semiconductor element connecting member 80 can be formed by heat treatment at low temperature for a brief period. The semiconductor device 2 can therefore exhibit higher reliability than the prior art.

The semiconductor device 2 can also be produced by the same process as the manufacturing process for a connection structure for a circuit member described above, using the board 60 and semiconductor element 50 as the first and second circuit members 20, 30 in the manufacturing process for a connection structure for a circuit member.

### Examples

The present invention will now be explained in greater detail based on examples and comparative examples, with the understanding that the invention is in no way limited to the examples.

### (Preparation of phenoxy resin)

There was dissolved 40 g of a phenoxy resin (trade name: YP-50, product of Tohto Kasei Co., Ltd.) in 60 g of methyl ethyl ketone to produce a solution with a solid content of 40 mass%.

### (Preparation of polyester-urethane resin)

A polyester-urethane resin (trade name: UR-1400, product of Toyobo, Ltd.) was used as a solution in a 1:1 (mass ratio) mixture of methyl ethyl ketone and toluene, with a solid content of 30 mass%.

### (Preparation of radical polymerizing compound)

Isocyanuric EO-modified diacrylate (trade name: M-215, product of Toagosei Co., Ltd.) was prepared.

### (Synthesis ofurethane acrylate)

In a reactor equipped with a stirrer, a thermometer, a reflux condenser with a calcium chloride drying tube and a nitrogen gas inlet tube, there were placed 860 g (1.00 mol) of poly(hexamethylene carbonate)diol (product of Aldrich Co.) with a number-average molecular weight of 860, and 5.53 g of dibutyltin dilaurate (product of Aldrich Co.). After introducing sufficient nitrogen gas into the reactor, it was heated to 70-75°C, and 666 g (3.00 mol) of isophorone diisocyanate (product of Aldrich Co.) was added dropwise over a period of 3 hours for reaction.

Upon completion of the dropwise addition, the reaction was continued for 10 hours. After further adding 238 g (2.05 mol) of 2-hydroxyethyl acrylate (product of Aldrich Co.) and 0.53 g of hydroquinone monomethyl ether (product of Aldrich Co.), reaction was continued for another 10 hours and suspended when IR measurement confirmed disappearance of isocyanate, to obtain urethane acrylate (UA). The number-average molecular weight of the obtained UA was 3700.

### (Preparation of phosphate group-containing vinyl compound)

A 2-(meta)acryloyloxyethyl phosphate product (trade name: LIGHT ESTER P-2M, product of Kyoeisha Chemical Co., Ltd.) was prepared.

### (Preparation of epoxy resin)

As an epoxy resin there was prepared a PO-modified BisA-type epoxy resin (trade name: ADEKARESIN EP-4010S, product of Adeka Corp.).

### (Preparation of organic fine particles)

As organic fine particles there were separately prepared an alkyl methacrylate ester-butadiene-styrene copolymer with a three-dimensional crosslinked structure (trade name: METABLEN C-223A, product of Mitsubishi Rayon Co., Ltd., Tg: -70°C, mean particle size: 400 nm) and an acrylic acid-silicone copolymer (trade name: CHALINE R-210, product of Nissin Chemical Industry Co., Ltd., Tg: -80°C, mean particle size: 200 nm).

### (Preparation of crosslinked polybutadiene particles)

Purified water was placed in a stainless steel autoclave, and then polyvinyl alcohol (product of Kanto Kagaku Co., Ltd.) was added as a suspending agent to form a solution. Butadiene (product of Aldrich Co.) was then added and the mixture was stirred to form a dispersion. Next, benzoyl peroxide (trade name: CADOX CH-50L, product of Kayaku Akzo Corp.) was added as a radical polymerization initiator and the mixture was further stirred to form a solution.

The autoclave was then heated to 60-65°C and polymerization was conducted for 45 minutes while stirring. After discharging the unreacted monomer, the produced crosslinked polybutadiene particles were filtered and washed with water and then with ethanol. The washed crosslinked polybutadiene particles were dried in a vacuum to obtain crosslinked polybutadiene particles (BR) with a mean particle size of 500 nm.

### (Preparation of radical polymerization initiator)

As a radical polymerization initiator there was prepared t-hexylperoxy-2-ethyl hexanoate (trade name PERHEXYL O, product of NOF Corp.).

### (Preparation of latent curing agent)

A sulfonium salt (trade name: SANAID SI-60L, product of Sanshin Chemical Industry Co., Ltd.) was prepared as a latent curing agent.

### (Formation of conductive particles)

A nickel layer was formed on the surface of polystyrene particles to a thickness of 0.2 µm, and then a layer made of gold was formed on the surface of the nickel layer to a thickness of 0.02 µm. This produced conductive particles having a mean particle size of 4 µm and a specific gravity of 2.5.

### (Examples 1-10, Comparative Examples 1-5)

All of the aforementioned materials were combined in the proportions listed in Table 1 in terms of solid mass ratio (units: parts by mass), and then the conductive particles were added and dispersed to a total solid volume of 1.5 vol% in the adhesive composition to obtain an adhesive composition. The obtained adhesive composition was coated onto a 80 µm-thick fluorine resin film with a coating apparatus and dried with hot air at 70°C for 10 minutes to obtain a film-like adhesive with an adhesive layer thickness of 20 µm.

**[Table 1]**

| | Thermoplastic resin | | Organic fine particles | | | Radical polymerizing compound | | Epoxy resin | Phosphoric acid-containing compound | Radical polymerization initiator | Latent curing agent |
|---|---|---|---|---|---|---|---|---|---|---|---|
| | Phenoxy resin | Polyester urethane resin | C-223A | R-210 | BR | M-215 | UA | EP-4010S | P-2M | Perhexyl O | M |
| Example 1 | 30 | - | 20 | - | - | 25 | 25 | - | 3 | 3 | - |
| Example 2 | - | 10 | - | 40 | - | 25 | 25 | - | 3 | 3 | - |
| Example 3 | 30 | - | 20 | - | - | 25 | 25 | - | 3 | 3 | - |
| Example 4 | - | 10 | - | 40 | - | 25 | 25 | - | 3 | 3 | - |
| Example 5 | 10 | - | 50 | - | - | 15 | 25 | - | 3 | 3 | - |
| Example 6 | - | 10 | - | 50 | - | 15 | 25 | - | 3 | 3 | - |
| Example 7 | 40 | - | 20 | - | - | - | - | 40 | - | - | 2 |
| Example 8 | 30 | - | 40 | - | - | - | - | 30 | - | - | 2 |
| Example 9 | 30 | - | 30 | - | - | - | - | 40 | - | - | 2 |
| Example 10 | - | - | 70 | - | - | 5 | 25 | - | 3 | 3 | - |
| Comp. Ex. 1 | 50 | - | - | - | - | 25 | 25 | - | 3 | 3 | - |
| Comp. Ex. 2 | - | 50 | - | - | - | 25 | 25 | - | 3 | 3 | - |
| Comp. Ex. 3 | - | 10 | - | - | 40 | 25 | 25 | - | 3 | 3 | - |
| Comp. Ex. 4 | 60 | - | - | - | - | - | - | 40 | - | - | 2 |
| Comp. Ex. 5 | 70 | - | - | - | - | - | - | 30 | - | - | 2 |

### [Measurement of bonding strength and connection resistance]

Each of the film-like adhesives obtained in the examples and comparative examples was used to bond together a flexible circuit board (FPC) having 500 copper circuits with a line width of 25 µm, a pitch of 50 µm and a thickness of 18 µm, with a glass board having a 0.2 µm-thick indium oxide (ITO) thin-layer (thickness: 1.1 mm, surface resistance: 20 Ω/sq.), by heat pressing for 10 seconds at a temperature of 160°C and a pressure of 3 MPa using a thermocompression bonding apparatus (heating system: constant heating, product of Toray Engineering). This produced a connected member (connection structure for a circuit member) comprising the FPC board and ITO substrate connected by the cured film-like adhesive across a width of 2 mm.

The resistance value (connection resistance) between the adjacent circuits of the connection structure was measured using a multimeter immediately after bonding and after holding for 250 hours in a high-temperature, high-humidity vessel at 85°C, 85% RH. The resistance value was expressed as the average of 37 resistance points between the adjacent circuits. The results are shown in Table 2.

The bonding strength of the connection structure was measured by the 90 degree peel method of JIS-Z0237 and evaluated. The bonding strength measuring apparatus used was a TENSILON UTM-4 (peel rate: 50 mm/min, 25°C, product of Toyo Baldwin Co., Ltd.). The results are shown in Table 2.

**[Table 2]**

| | Connection resistance (Ω) | | Bonding strength (N/m) | |
|---|---|---|---|---|
| | After bonding | After 250h | After bonding | After 250h |
| Example 1 | 1.3 | 2.3 | 710 | 630 |
| Example 2 | 1.2 | 2.4 | 720 | 640 |
| Example 3 | 1.1 | 2.2 | 760 | 690 |
| Example 4 | 1.5 | 2.8 | 790 | 630 |
| Example 5 | 1.6 | 2.5 | 750 | 640 |
| Example 6 | 1.2 | 2.1 | 740 | 690 |
| Example 7 | 1.5 | 2.4 | 780 | 630 |
| Example 8 | 1.4 | 2.3 | 750 | 680 |
| Example 9 | 1.3 | 2.1 | 760 | 620 |
| Example 10 | 1.8 | 2.4 | 700 | 600 |
| Comp. Ex. 1 | 2.7 | 3.9 | 370 | 270 |
| Comp. Ex. 2 | 2.8 | 4.4 | 350 | 280 |
| Comp. Ex. 3 | 6.9 | 12.9 | 580 | 370 |
| Comp. Ex. 4 | 2.6 | 3.6 | 400 | 390 |
| Comp. Ex. 5 | 2.4 | 4.1 | 380 | 360 |

As seen by the results shown in Table 2, the film-like adhesives obtained in Examples 1-10 exhibited satisfactory connection resistance and bonding strength both immediately after bonding and after holding for 250 hours in a high-temperature, high-humidity vessel at 85°C, 85% RH, under connecting conditions with a heating temperature of 160°C and a time of 10 seconds, thus confirming that they had satisfactory properties.

In contrast, Comparative Examples 1-2 and 4-5 which did not use organic fine particles according to the invention had inferior bonding strength both immediately after bonding and after high-temperature, high-humidity treatment, with reduced bonding strength and increased connection resistance being observed after the high-temperature, high-humidity treatment. In Comparative Example 3 which used crosslinked polybutadiene particles instead of organic fine particles according to the invention, the connection resistance was inferior both immediately after bonding and after high-temperature, high-humidity treatment, with a significant decrease in bonding strength and a significant increase in connection resistance being observed after the high-temperature, high-humidity treatment.

### Industrial Applicability

As explained above, it is possible according to the invention to provide an adhesive composition which exhibits excellent bonding strength and can maintain stable performance even after reliability testing (for example, standing at 85°C/85% RH), as well as a film-like adhesive and a connection structure for a circuit member employing it.

## Claims

1. An adhesive composition comprising (a) organic fine particles comprising at least one selected from the group consisting of alkyl (meth)acrylate ester-butadiene-styrene copolymer or complexes thereof, alkyl (meth)acrylate ester-silicone copolymer or complexes thereof and silicone-(meth)acrylic acid copolymer or complexes thereof.

2. An adhesive composition according to claim 1, which further comprises (b) a radical polymerizing compound and (c) a radical polymerization initiator.

3. An adhesive composition according to claim 1, which further comprises (d) an epoxy resin and (e) a latent curing agent.

4. An adhesive composition according to any one of claims 1 to 3, wherein the Tg of the (a) organic fine particles is -100 to 70°C.

5. An adhesive composition according to any one of claims 1 to 4, wherein the (a) organic fine particles are particles comprising a polymer with a three-dimensional crosslinked structure.

6. An adhesive composition according to any one of claims 1 to 5, wherein the (a) organic fine particles are particles comprising a polymer with a weight-average molecular weight of 1,000,000-3,000,000.

7. An adhesive composition according to any one of claims 1 to 6, wherein the content of the (a) organic fine particles is 5-80 mass% based on the total solid mass of the adhesive composition.

8. An adhesive composition according to any one of claims 1 to 7, wherein the (a) organic fine particles are particles with a core-shell structure.

9. An adhesive composition according to any one of claims 1 to 8, which further comprises (f) a vinyl compound with one or more phosphate groups in the molecule.

10. An adhesive composition according to any one of claims 1 to 9, which further comprises (g) a thermoplastic resin.

11. An adhesive composition according to claim 10, wherein the (g) thermoplastic resin includes at least one selected from the group consisting of phenoxy resins, polyester resins, polyurethane resins, polyester-urethane resins, butyral resins, acrylic resins and polyimide resins.

12. An adhesive composition according to any one of claims 1 to 11, which further comprises (h) conductive particles.

13. A film-like adhesive obtained by forming an adhesive composition according to any one of claims 1 to 12 into the shape of a film.

14. A connection structure for a circuit member comprising
a pair of mutually opposing circuit members, and
a connecting member formed between the pair of circuit members which bonds the pair of circuit members together so that the respective circuit electrodes of the pair of circuit members are electrically connected together,
wherein the connecting member comprises a cured adhesive composition according to any one of claims 1 to 12.
